# EUROPÄISCHE PATENTANMELDUNG

(11) **EP 0 875 953 A2**
(43) Veröffentlichungstag der Anmeldung: **04.11.1998**
(21) Anmeldenummer: 98102343.5
(22) Anmeldetag: 11.02.1998
(51) Int. Cl.: H01M 10/48, G01R 31/36

(54) **Elektrischer Akkumulator**

(30) Priorität: 03.05.1997 DE 19718781
(71) Anmelder: VB Autobatterie GmbH, D-30419 Hannover (DE)
(72) Erfinder: Richter, Gerolf, Dr., 31139 Hildesheim (DE)
(74) Vertreter: Kaiser, Dieter Ralf, Dipl.-Ing.

(57) **Zusammenfassung**

Bei einem elektrischen Akkumulator ist in den Behälter ein elektronischer Baustein zur Funktionsüberwachung in Form einer elektronischen Uhr integriert. Die Frequenz der elektronischen Uhr wird in Abhängigkeit von mindestens einer Kenngröße des Akkumulators verändert.

Dabei wird die Frequenz der elektronischen Uhr mit zunehmender Elektrolyttemperatur und zunehmender Abweichung der Klemmenspannung von der Ruhespannung des Akkumulators erhöht.

Insbesondere ist die elektronische Uhr mit einer in den Elektrolyten eintauchenden Meßsonde gekoppelt, über welche die Spannungsversorgung der elektronischen Uhr, die Temperaturmessung des Akkumulators und die Messung des Elektrolytniveaus erfolgt.

## Beschreibung

Gegenstand der Erfindung ist ein elektrischer Akkumulator mit einem in den Behälter integrierten elektronischen Baustein zur Funktionsüberwachung in Form einer elektronischen Uhr.

Das Bestreben der Akkumulatorenhersteller und der Fahrzeuglieferanten die Starterbatterie als geschlossenen, nicht mehr zu öffnenden, aber mit Säure gefüllten und elektrisch geladenen Energiespeicher anzubieten und einzusetzen, hat zur Folge, daß eine Aussage über den Zustand eines solchen Systems nur noch schwer möglich ist. Beim klassischen, mit Zellenstopfen versehen Bleiakkumulator konnte der Batteriezustand durch eine Ruhespannungsmessung in Kombination mit einer Säuredichtekontrolle relativ schnell mit einfachen Mitteln am bereits eingebauten Akkumulator durchgeführt werden.

Bei geschlossenen Batterien ist der Grad des Verschleißes und damit der Zeitpunkt eines vorbeugenden Austausches nur über einen Belastungstest mit elektronischer Auswertung möglich, wobei allerdings eine das Lebensdauerende signalisierende Leistungseinbuße in einer der sechs Zellen einer üblichen Starterbatterie nur sehr schwer zu erkennen ist.

Da die Wartungsintervalle bei modernen Kraftfahrzeugen immer länger geworden sind und der Akkumulator an seinem Einbauort teilweise auch nur schwer zugänglich ist, wird dieses Informationsdefizit über die Lebensdauererwartung einer Starterbatterie noch verstärkt.

Anderseits wird eine erhöhte Zuverlässigkeit der Starterbatterie gefordert, da in den Fahrzeugen mehr elektrische Komponenten montiert sind und insbesondere die Zahl der Verbraucher mit hoher Relevanz für die Fahrtüchtigkeit des Fahrzeugs stetig zunimmt. Unterstrichen wird die Zuverlässigkeitsforderung an die Batterie durch eine Vielzahl von elektrisch betriebenen Sicherheitssystemen im Fahrzeug.

Daneben haben sich die Betriebsbedingungen für Starterbatterien teilweise verschlechtert. Als lebensdauereinschränkend sind insbesondere hohe Ladungsdurchsätze bei Fahrzeugen mit kompletter elektrischer Ausstattung, die permanente Ladungsunterdeckung im städtischen Stop und Go-Verkehr, sowie der häufige Einsatz von Automobilen in heißen Klimaten zu betrachten, denn durch hohe Temperaturen wird die für den vorzeitigen Batterieausfall verantwortliche Korrosion der Bleistrukturteile im Bleiakkumulator überproportional begünstigt.

Es besteht daher bei Einsatz geschlossener absolut wartungsfreier Akkumulatoren, insbesondere im Kraftfahrzeug, der Bedarf durch eine ständige Anzeige oder bei periodischem Service dem Wartungspersonal per Diagnosestecker den Zustand des Energiespeichers bezüglich der noch zu erwartenden Lebensdauer zu signalisieren.

In diesem Zusammenhang ist es bereits bekannt, die Funktion eines Akkumulators, insbesondere die Lebensdauer einer Akkumulatorenbatterie, dadurch zu überwachen, daß in den Gehäusedeckel ein Uhrenchip mit einem Display integriert ist, der über Anschlußleiter an die Batteriepole angeschlossen ist und der mit dem Einfüllen des Säureelektrolyten in den Akkumulator mit einer selbsttätigen Zählung und Anzeige der Betriebszeit beginnt. Eine solche Anordnung kann allerdings nur den Zeitablauf seit Beginn der Betriebsfähigkeit des Akkumulators messen, weitere Parameter, wie insbesondere der Verlauf der Temperatur, der der Akkumulator ausgesetzt ist oder wechselnde Belastungen werden dabei nicht berücksichtigt.

Der Erfindung liegt daher die Aufgabe zugrunde, einen elektrischen Akkumulator anzugeben, bei dem eine Anzeige der Lebensdauer bzw. der noch vorhandenen Restlebensdauer ermöglichtwird.

Diese Aufgabe wird bei einem elektrischen Akkumulator der eingangs genannten Art durch die Merkmale des kennzeichnenden Teils des Anspruchs 1 gelöst. Vorteilhafte Ausgestaltungen eines solchen Akkumulators sind in den Unteransprüchen genannt.

Erfindungsgemäß ist in den Akkumulator eine Uhr integriert, deren Frequenz variabel ist und in Abhängigkeit von mindestens einer Kenngröße des Akkumulators verändert wird. Die vom Akkumulator gelieferten analogen Signale können über einen miniaturisierten Rechnerchip digitalisiert und mit Hilfe einfacher Algorithmen verarbeitet werden und zur Ansteuerung der elektronischen Uhr dienen.

Die Energieversorgung der elektronischen Uhr erfolgt durch den Akkumulator selbst, durch einen galvanischen Kontakt über in den Deckel oder Behälter eingelassene Anschlußleiter oder über auf Folien angeordnete Leiterbahnen mit den Polen der Batterie, bzw. über einen Leiter oder eine Leiterbahn zum Pluspol und einen Anschluß an einen stiftförmigen Sensor aus Blei, der in den Elektrolyten der negativen Endzelle eintaucht. Über den zur Schließung des Stromkreises der elektronischen Uhr erforderlichen Sensorstift aus Blei kann zusätzlich das Unterschreiten eines Mindestsäureniveaus und durch entsprechende Anordnung eines Temperatursensors auch die Temperatur des Elektrolyten kontrolliert und ermittelt werden. Gleichzeitig kann mit dieser Anordnung die zeitliche Änderung der Klemmenspannung des Akkumulators gemessen werden.

Mit einer erfindungsgemäßen Anordnung kann zu jedem beliebigen Zeitpunkt die Elektrolyttemperatur in einer als repräsentativ für den Akkumulator geltenden Zelle gemessen werden und die Klemmenspannung des Akkumulators kann in guter Näherung bestimmt werden. Das Unterschreiten eines Mindestsäureniveaus in der repräsentativen Zelle wird gemessen und der Rechnerchip sowie die Digitaluhr wird über den Sensorstift mit Strom versorgt.

Die eingehenden Meßgrößen werden innerhalb vorgegebener Zeitintervalle von beispielsweise 1 bis 10 min. verarbeitet. Während eines Meßzeitintervalls wird der Mittelwert der Klemmenspannung des Akkumulators gebildet. Der so ermittelte Wert wird mit der Batterieruhespannung verglichen. Liegt die Klemmenspannung über der Ruhespannung, ist die Batterie geladen worden, d.h. es erfolgte ein masseschädigender Ladungsdurchsatz und Korrosion durch Überspannung. Im Falle, daß die Klemmenspannung unterhalb der Ruhespannung liegt, ist die Batterie entladen worden, d.h. daß wiederum ein masseschädigender Ladungsdurchsatz vorlag oder die Batterie lagert in einem teilentladenen Zustand und unterliegt einer Standzeitkorrosion.

Der Grad der Abweichung des im Zeitintervall ermittelden Spannungsdurchschnittwertes von der Ruhespannung wird im Rechnerchip gewichtet, wobei die Fälle Überschreitung und Unterschreitung unterschiedlich behandelt werden und die Frequenz der Uhr wird entsprechend gesteuert.

Ebenso wird in jedem Meßzeitintervall der Mittelwert der Elektrolyttemperatur gebildet und mit einer Normaltemperatur von beispielsweise 25°C verglichen. Liegt die Abweichung über der Normaltemperatur, begünstigt die erhöhte Elektrolyttemperatur alle Alterungsvorgänge, wie Korrosion und Masseschlammung. Im Falle tieferer Temperaturen als normal werden diese chemischen Vorgänge verzögert. Auch der Grad der Abweichung des im Zeitintervall ermittelten Temperaturdurchschnitts von der Normaltemperatur wird im Rechnerchip gewichtet und beeinflußt dementsprechend die Frequenz.

Der die Frequenz bestimmende Teil der Digitaluhrschaltung wird mit den errechneten Größen aus Temperatur und Klemmenspannungsabweichung derartig beaufschlagt, daß sich die Frequenz bei hohen Elektrolyttemperaturen und großen Abweichungen der Klemmenspannung von der Ruhespannung in beiden Richtungen erhöht und bei niedriger Elektrolyttemperatur erniedrigt. Die Digitaluhrschaltung ist dabei so eingestellt, daß im Grenzfall, nämlich unter Normalbedingungen, die Uhr bei einer dann zu erwartenden Lebensdauer von beispielsweise 5 Jahren stehen bleibt. Auch eine Unterbrechung der Stromversorgung, d.h. eine Unterschreitung des Elektrolytmindestniveaus, sowie die Unterschreitung einer als untere Grenze definierten Klemmenspannung führt ebenfalls zu einem Stillstand der Uhr. Der Benutzer bzw. das Wartungspersonal kann daraus wichtige Informationen über den Zustand der Batterie ableiten und kann beispielsweise bei Stillstand der Uhr den Akkumulator sofort austauschen und gegebenenfalls die Ausfallursache ermitteln, wenn die kalendarische Lebensdauer demgegenüber als ungewöhnlich kurz empfunden wird. Solange die erfindungsgemäße Lebensdaueruhr läuft, ist eine Vorhersage des erforderlichen Batterieaustausches aus dem Verhältnis der Anzeige der Lebensdaueruhr zu der kalendarischen Lebensdauer möglich.

## Patentansprüche

1. Elektrischer Akkumulator mit einem in den Behälter integrierten elektronischen Baustein zur Funktionsüberwachung in Form einer elektronischen Uhr, dadurch gekennzeichnet, daß die Frequenz der elektronischen Uhr in Abhängigkeit von mindestens einer Kenngröße des Akkumulators verändert wird.

2. Elektrischer Akkumulator nach Anspruch 1, dadurch gekennzeichnet, daß die Frequenz der elektronischen Uhr mit zunehmender Elektrolyttemperatur und zunehmender Abweichung der Klemmenspannung von der Ruhespannung des Akkumulators erhöht wird.

3. Elektrischer Akkumulator nach den Ansprüchen 1 oder 2, dadurch gekennzeichnet, daß die elektronische Uhr mit einer in den Elektrolyten eintauchenden Meßsonde gekoppelt ist, über welche die Spannungsversorgung der elektronischen Uhr, die Temperaturmessung des Akkumulators und die Messung des Elektrolytniveaus erfolgt.

4. Elektrischer Akkumulator nach einem der Ansprüche 1 bis 3, dadurch gekennzeichnet, daß die elektronische Uhr ihren Stillstand signalisiert, sobald ein vorgegebener Laufzeitsollwert erreicht ist oder eine vorgegebene untere Grenze der Klemmenspannung unterschritten wird oder die Stromversorgung durch Unterschreitung des Säureniveaus in der Akkumulatorenzelle unterbrochen ist.

5. Elektrischer Akkumulator nach einem oder mehreren der Ansprüche 1 bis 4, dadurch gekennzeichnet, daß die Energieversorgung der elektronischen Uhr durch eine Leiterbahn zum Pluspol eines mehrzelligen Akkumulators und durch einen stiftförmigen aus Blei bestehenden Sensor, der in den Elektrolyten der negativen Endzelle eintaucht, erfolgt.
